Europäisches Patentamt

European Patent Office

Office européen des brevets

(11) Publication number: **0 428 908 A1**

## EUROPEAN PATENT APPLICATION

(21) Application number: 90120573.2

(22) Date of filing: 26.10.90

(51) Int. Cl.⁵: **F28D 15/02, F28F 1/12, B23K 20/10**

(30) Priority: 30.10.89 JP 283644/89
30.10.89 JP 283645/89

(43) Date of publication of application:
**29.05.91 Bulletin 91/22**

(84) Designated Contracting States:
**DE FR GB**

(71) Applicant: **MITSUBISHI JUKOGYO KABUSHIKI KAISHA**
**5-1, Marunouchi 2-chome Chiyoda-ku**
**Tokyo 100(JP)**

Applicant: **SANWABOSEI CO., LTD.**
**35-23, Kajimachi 3-chome,**
**Moriguchi-shi, Osaka(JP)**

Applicant: **Mitsubishi Cable Industries, Ltd.**
**8, Nishino-cho Higashimukaijima**
**Amagasaki-shi**
**Hyogo-ken 660(JP)**

(72) Inventor: **Kishimoto, Kenji,c/o Nagoya**
**Guidance & Prop. Works**
Mitsubishi Jukogyo K.K., 1200, Higashi
Tanaka
Komaki-shi, Aichi-ken(JP)
Inventor: **Togowa, Morito, c/o Nagoya**
**Guidance & Prop. Works**
Mitsubishi Jukogyo K.K., 1200, Higashi
Tanaka
Komaki-shi, Aichi-ken(JP)
Inventor: **Okada, Masuo**
c/o Sanwabosei Co., Ltd., 35-23, Kajimachi
3-chome
Moriguchi-shi, Osaka(JP)
Inventor: **Yoshikawa, Makoto, c/o Mitsubishi**
**Cable Ind., Ltd.**
8, Hishinocho, Higashimukaijima
Amagasaki-shi, Hyogo-ken(JP)
Inventor: **Kajikawa, Hiroshi, c/o Mitsubishi**
**Cable Ind., Ltd.**
8, Hishinocho, Higashimukaijima
Amagasaki-shi, Hyogo-ken(JP)

(74) Representative: **Reinhard, Skuhra, Weise**
**Friedrichstrasse 31**
**W-8000 München 40(DE)**

(54) Heat transfer pipe and method of making the same.

㉗ The present invention provides a heat transfer pipe comprising a metallic pipe body (3) and at least one metallic wire fin (4) continuously extending longitudinally of the pipe body. The wire fin is waved to have alternate crests (5) and furrows (6), and attached to the outer surface of the pipe body at the furrows by application of supersonic vibration.

Fig. 1

## HEAT TRANSFER PIPE AND METHOD OF MAKING THE SAME

This invention generally relates to heat transfer pipes, and more particularly to finned heat transfer pipes for use in heat exchangers. The present invention also relates to a method of making such a heat transfer pipe.

As is well known, heat transfer pipes are used in various applications for performing heat exchange between two kinds of fluids flowing respectively inside and outside the pipes. Usually, the heat transfer pipe is finned to increase the heat transmission surface area, thereby enhancing the heat exchange efficiency.

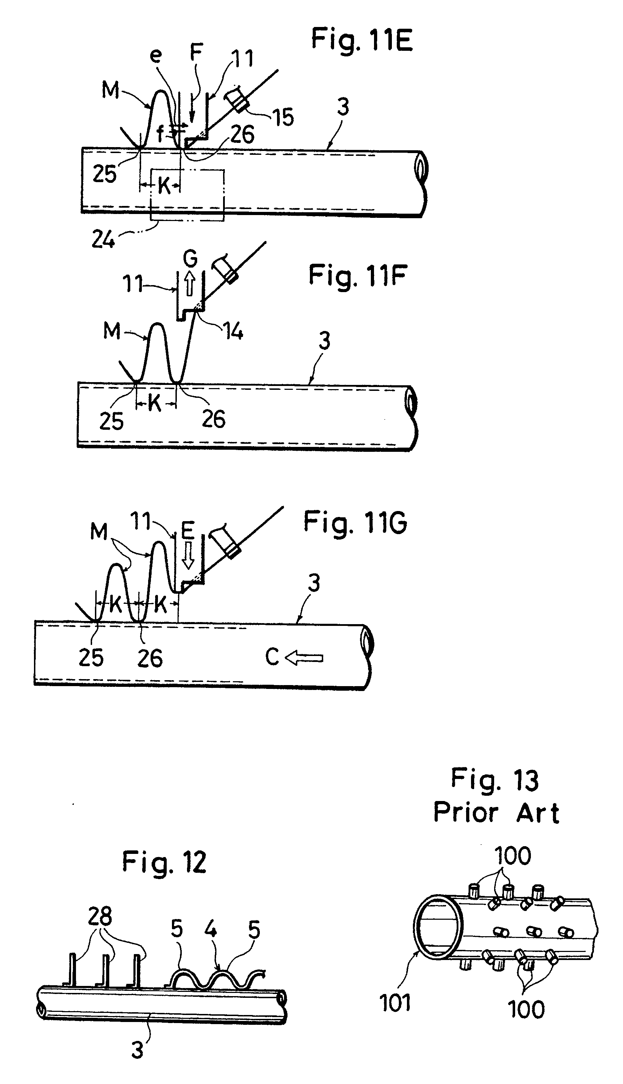

Indeed, there have been proposed various types of finned heat transfer pipes in an attempt to maximize the heat exchange efficiency while also meeting the requirements for small size and light weight. Fig. 13 shows an example of finned heat transfer pipe which has resulted from such an attempt.

Referring to Fig. 13, the prior art heat transfer pipe comprises a pipe body 101 usually made of stainless steel, and a multiplicity of needle fins 100 fixed to the outer surface of the pipe body. The needles are fixed to the pipe body by resistance welding.

Due to the use of the needle fins 100, the prior art heat transfer pipe is known to be relatively light and compact. However, this heat transfer pipe is disadvantageous in the following respects.

First, it is difficult to efficiently and properly fix, by resistance welding, separate needles 100 which are very thin and small. Particularly, when using the heat transfer pipe in a heat exchanger for an air liquefaction cycle rocket engine for example, super-thin needles 100 having a diameter of 300 μm and a length of 1-4mm must be fixed to a pipe body 101 having an outer diameter of several millimeters. Therefore, it is .difficult to efficiently supply the needles for resistance welding, which results in great supply loss and low productivity. Further, the strength reliability at the welding points is rather low. Moreover, thermal deformation of the pipe body 101 becomes problematic when the wall thickness thereof is small.

Second, for an application in the air liquefaction cycle rocket engine, even if a single needle 100 is improperly welded, it may easily come off from the pipe body 101 to get into the liquefied air. Obviously, such an impurity inclusion can cause a vital problem for the rocket engine. Thus, the use of the needle fin heat transfer pipe in the rocket engine should be avoided as long as this problem remains unsolved.

Third, the resistance welding can be used only when the needles 100 are made of a material which is identical or similar to the material of which the pipe body 101 is made. Thus, since the pipe body is usually made of stainless steel, the needles must be also made of stainless steel. Such a limitation in the choice of fin material excludes the use of a light metal such aluminum, consequently preventing further weight reduction of the heat exchanger.

It is, therefore, an object of the present invention to provide a finned heat transfer pipe which can be rendered light and compact.

Another object of the present invention is to provide a finned heat transfer pipe in which the fins can be reliably fixed to preclude unexpected detachment thereof, thereby increasing the operational reliability of the heat transfer pipe for application even to an air liquefaction cycle rocket engine.

A further object of the present invention is to provide a finned heat transfer pipe which enables the use of various fin materials to realize maximum weight reduction.

Still another object of the present invention is to provide a method of making a finned heat transfer pipe which enables reliably and efficiently attaching the fins to the pipe body within a short time even if the pipe body and the fins are made of different metals.

According to one aspect of the present invention, there is provided a heat transfer pipe comprising a metallic pipe body, and fin means attached to the pipe body; characterized in that the fin means comprises at least one metallic wire fin continuously extending longitudinally of the pipe body, the wire fin being waved to have alternate crests and furrows, the wire fin being attached to the outer surface of the pipe body at the furrows.

According to another aspect of the present invention, there is provided a method of making a heat transfer pipe which comprises a metallic pipe body; and at least one metallic wire fin continuously extending longitudinally of the pipe body, the wire fin being waved to have alternate crests and furrows, the wire fin being attached to the outer surface of the pipe body at the furrows; the method being characterized by repeating the steps of: causing a vibratory bonding tool to press a portion of a metallic wire against the outer surface of a pipe body at a longitudinal position thereof while the bonding tool is supersonically vibrated, so that the portion of the wire is attached to the pipe body; separating the bonding tool from the pipe body transversely thereof while the wire is paid out; and causing the bonding tool to press another portion of the wire against the outer surface of the pipe body at another longitudinal position thereof while the tool is supersonically vibrated, so that the another portion of the wire is attached to the pipe body with a wire part between the two adjacent attaching portions being bent to form a crest.

The present invention will now be described further, by way of example only, with reference to the accompanying drawings, in which:

Fig. 1 is a perspective view showing a finned heat transfer pipe embodying the present invention;

Fig. 2 is a view, in transverse section, showing the same heat transfer pipe;

Fig. 3 is a perspective view showing a heat exchanger incorporating a plurality of finned heat transfer pipes according to the embodiment shown in Figs. 1 and 2;

Fig. 4 is a schematic view, in transverse section, showing the arrangement of the heat transfer pipes in the same heat exchanger;

Fig. 5 is a view, in transverse section, showing another finned heat transfer pipe embodying the present invention;

Fig. 6 is a view, also in transverse section, showing a further finned heat transfer pipe embodying the present invention;

Fig. 7A is a perspective view showing a supersonic bonding unit used for making the finned heat transfer pipe according to the present invention;

Fig. 7B is also a perspective view showing another supersonic bonding unit for making the finned heat transfer pipe according to the invention;

Fig. 8 is a side view showing an overall apparatus incorporating the supersonic bonding unit shown in Fig. 7A;

Fig. 9 is a front view showing the same apparatus;

Fig. 10 is a sectional front view showing a principal portion of the same apparatus;

Figs. 11A through 11G are schematic views showing the successive steps of attaching a wire fin to the pipe body;

Fig. 12 is a side view showing still another finned heat transfer pipe embodying the present invention; and

Fig. 13 is a perspective view showing a prior art finned heat transfer pipe.

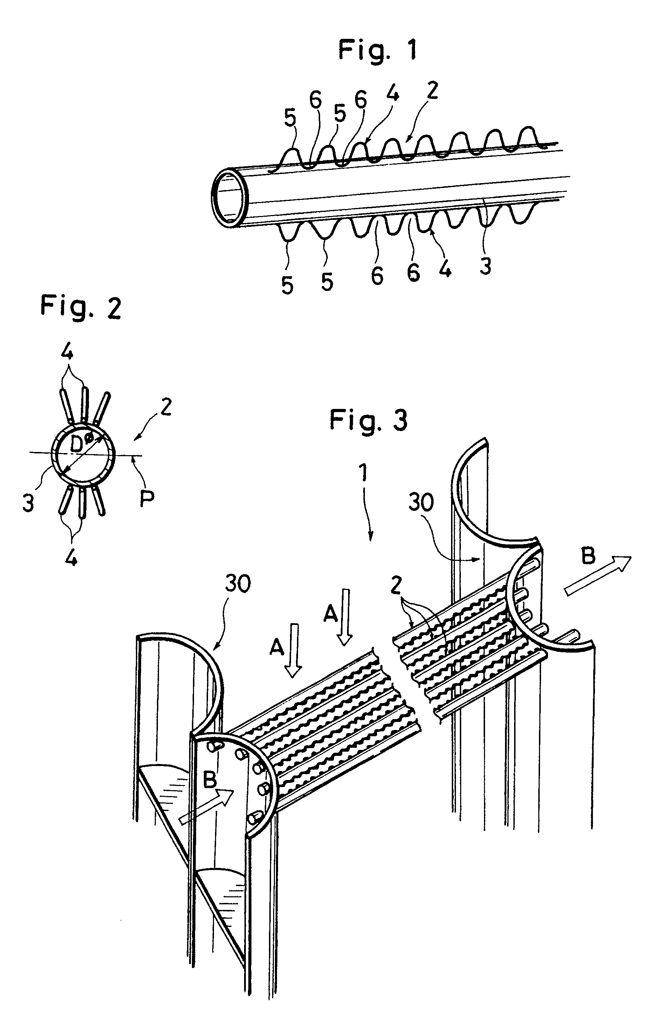

Throughout Figs. 1 to 12 of the accompanying drawings, like parts are designated by the same reference numerals for the convenience of illustration.

Referring first to Fig. 3, there is illustrated a heat exchanger 1 which incorporates a plurality of heat transfer pipes 2 according to the present invention. The respective heat transfer pipes are shown to extend between a pair of arcuately waved side walls 30. It should be appreciated that Fig. 3 shows only five of the heat transfer pipes which are actually provided in such a number that occupies substantially the entire space of the heat exchanger.

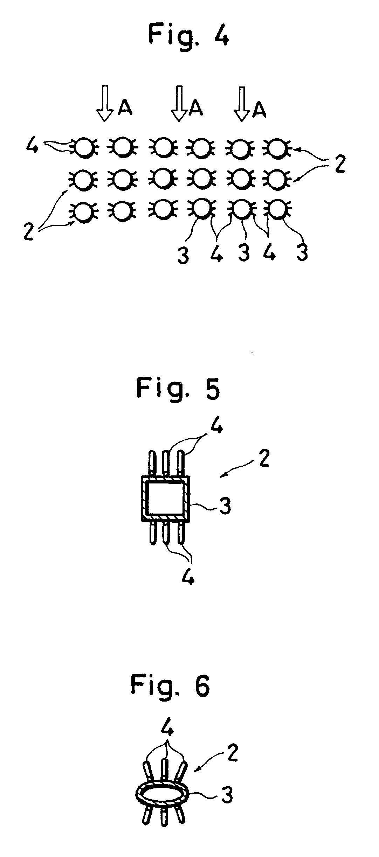

Within the heat exchanger 1, the heat transfer pipes 2 are arranged in rows such that corresponding pipes in the respective rows form aligned columns, as shown in Fig. 4. Alternatively, the heat transfer pipes may be arranged in a manner such that the pipes of the respective rows are staggered.

The illustrated heat exchanger 1 may be used for liquefying air in an air liquefaction cycle rocket engine. In such an application, the air is allowed to flow in the direction of arrow A outside the heat transfer pipes 2, whereas liquefied hydrogen is passed in the direction of arrow B within the pipes. The air is liquefied upon cooling by the liquefied hydrogen.

As shown in Figs. 1 and 2, each of the heat transfer pipes 2 comprises a pipe body 3 and a plurality of wire fins 4 attached to the outer surface of the pipe body. Each wire fin 4 extends longitudinally of the pipe body 3, and is continuously waved to have alternate crests 5 and furrows 6. The wire fin is attached to the outer surface of the pipe body at the furrows.

According to the embodiment shown in Figs. 1 and 2, the pipe body 3 is circular in cross section. As shown in Fig. 2, the wire fins 4 are arranged symmetrically with respect to a central longitudinal plane P of the pipe body 3 in a manner such that the respective wire fins project generally transversely to the longitudinal plane P. Such an arrangement is preferred because the thermal efficiency of the heat transfer pipe increases most when the fins project in a direction generally transversing the flow direction A of the fluid (see Figs. 3 and 4). However, in certain applications, it may be advantageous to arrange the wire fins at equal angular spacing. The wire fins may be provided in any number depending on various requirements.

The cross-sectional shape of the pipe body 3 may be square (or polygonal), as shown in Fig. 5. Alternatively, the cross-sectional shape of the pipe body may be ellipsoidal, as shown in Fig. 6.

The pipe body 3 may be preferably made of a metal selected from a group consisting of stainless steel, nickel, nickel alloy, titanium, titanium alloy, niobium, niobium alloy and copper. On the other hand, the wire fin may be preferably made of aluminum or copper.

When the heat exchanger 1 is used for liquefying air, the pipe body 3 may be made to have an outer diameter of e.g. about 2-10mm, whereas the wire fins may be made to have a diameter of e.g. about 25-500 $\mu$m. Further, the pitch and height of the wire wave may be suitably determined depending on various requirements.

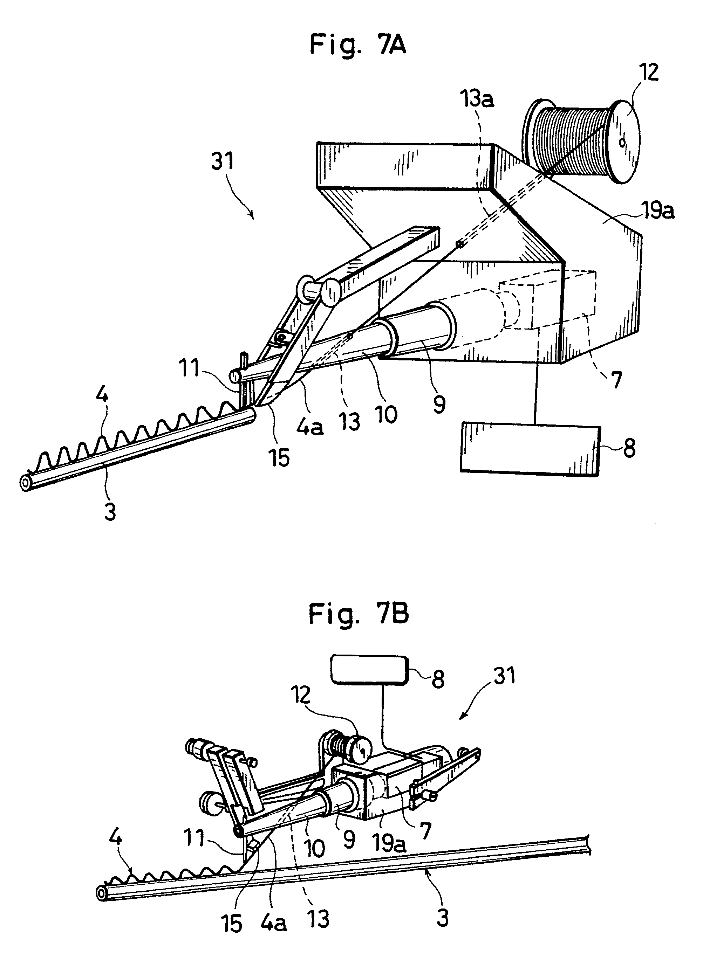

The finned heat transfer pipe described above may be manufactured by using a supersonic bonding unit 31 such as shown in Fig. 7A. Specifically, the bonding unit comprises a supersonic vibrator 7 for generating supersonic vibration of e.g. 60KHz in response to electrical signals from a supersonic generator 8. The bonding unit further comprises a cone 9 and a horn 10 both of which are connected to the supersonic vibrator for amplifying the supersonic vibration. The horn 10 is provided at its front end with a vertical bonding tool 11 which receives the amplified vibration.

The supersonic vibrator 7 together with the cone 9 and the horn 10 is supported by a unit box 19a. A spool 12 for continuously supplying a material wire 4a is arranged above and behind the unit box. The wire paid out from the spool is passed through a guide hole 13a of the unit box, and then through another guide hole 13 of the horn 10.

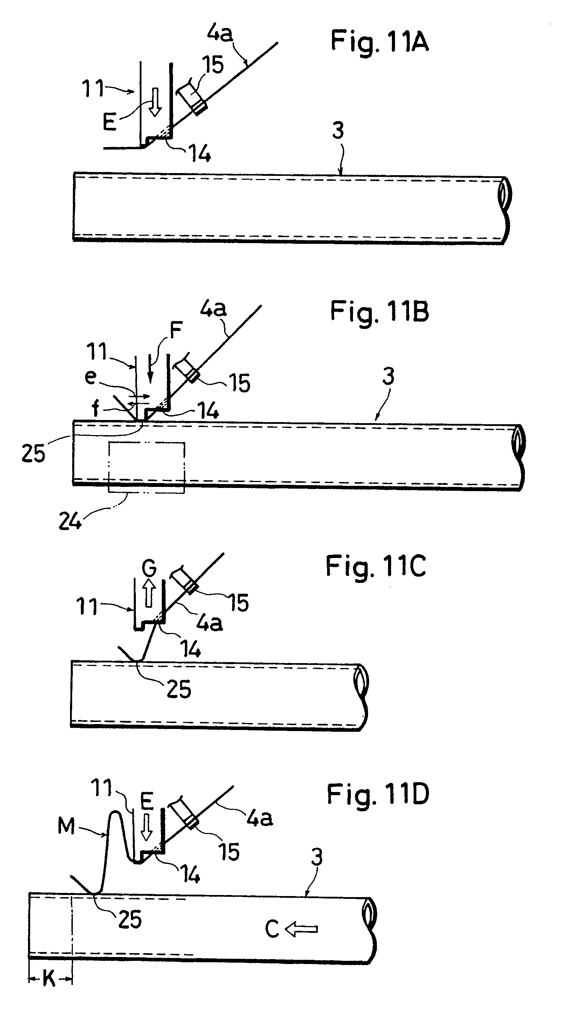

The bonding tool 11 is also formed at its lower end with a guide hole 14 (see Figs. 11A to 11G) for receiving the material wire 4a. Slightly before the lower end of the bonding tool is arranged a clamp 15 for releasably nipping the wire. The clamp may be supported by the unit box 19a.

A pipe body 3 undergoing a bonding operation is held substantially in parallel to the horn 10 with the material wire 4a interposed between the bonding tool 11 and the pipe body.

In operation, the bonding tool is pressed transversely against the pipe body 3 with a predetermined force. Thus, when the bonding tool is supersonically vibrated, a portion of the material wire 4a located immediately under the bonding tool is supersonically slided longitudinally relative to the pipe body, consequently generating frictional heat. As a result, the surface layer of the wire is abrasively broken to thermally fuse to the pipe body within a short time.

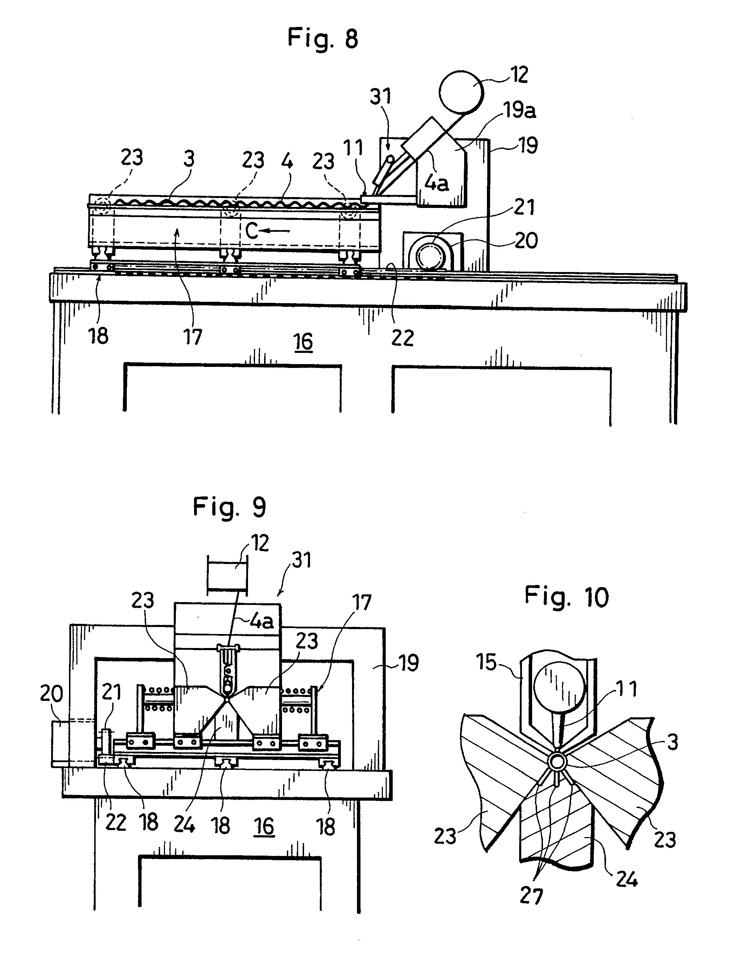

Figs. 8 and 9 show an overall manufacturing apparatus which incorporates the supersonic bonding unit 31. Specifically, the box 19a of the bonding unit is mounted on a unit support 19 which, in turn, is fixed on a bed 16. The box 19a is movable vertically relative to the unit support 19 by an unillustrated mechanism.

Guide rails 18 are provided on the bed 16 for movably guiding a carriage 17 which carries the pipe body 3 in horizontal state. The carriage is provided with a rack 22 in mesh with a pinion 21 which is reversibly rotated by a pulse motor 20. Thus, the carriage is horizontally moved back and forth with the pipe body when the pulse motor is rotated forward and backward.

At each of three positions spaced longitudinally of the pipe body 3 (see Fig. 8), there is provided a pair of side jigs 23 for holding the pipe body in cooperation with a lower jig 24, as best shown in Fig. 10. These jigs need to hold the pipe body in such a manner that the pipe body does not vibrate with the bonding tool 11 since no bonding occurs in the absence of relative vibratory sliding movement between the pipe body and the material wire 4a. Preferably, the lower jig 24 is provided with longitudinal cutouts 27 for accommodating the wire fins which have been formed prior to the one instantly undergoing the bonding operation.

The supersonic bonding unit shown in Fig. 7A may be replaced by a modified bonding unit shown in Fig. 7B. The modified bonding unit differs from the foregoing one in that the unit box 19a is smaller, that the wire spool 12 is arranged slightly ahead of the unit box (the box therefore having no guide hole), that the clamp 15 is differently configured. Otherwise, both of the bonding units are substantially identical in arrangement and function.

Using the apparatus described above, each waved wire fin 4 is attached to the pipe body 3 in the following manner.

As shown in Fig. 11A, the material wire 4a is inserted through the guide hole 14 of the bonding tool 11 with the clamp 15 opened. Then, the clamp 15 is closed, and the bonding tool is moved (lowered) toward the pipe body 3, as shown by arrow E. The pipe body has been previously subjected to electrolytic or mechanical polishing to have a surface roughness of not more than $0.5\mu mRa$ for example. The material wire 4a is made for example of aluminum, and has a thickness of 25-500 $\mu m$.

As shown in Fig. 11B, the bonding tool 11 is subsequently pressed against the pipe body 3 with a force F of e.g. 30-1,200g while the bonding tool is supersonically vibrated in the directions of arrows e and f. As a result, the material wire 4a is heated at the tool tip by the supersonic energy (as partly converted to frictional heat) to be bonded to the pipe body at a first portion 25. Usually, the supersonic vibration may be applied for a period of 0.25-2 seconds. However, the supersonic application time may vary depending on the supersonic output.

The supersonic vibration is temporarily stopped upon completion of the first bonding step. Then, the clamp 15 is opened, and the bonding tool 11 is raised away from the pipe body 3, as indicated by arrow G in Fig. 11C. At this time, the material wire 4a is tensionally supplied for a length determined by the upward stroke of the bonding tool.

Thereafter, the pipe body 3 is longitudinally advanced by a predetermined pitch K, as indicated by arrow C in Fig. 11D. This advancing movement is acheived by the combination of the pulse motor 20, the pinion 21 and the rack 22 (see Fig. 8). Obviously, the advancing movement of the pipe body causes the material wire 4a to be additionally paid out. It should be appreciated that the pipe body may be longitudinally advanced simultaneously with raising of the bonding tool 11, namely simultaneously with the process step of Fig. 11C.

Subsequently, the clamp 15 is closed, and the bonding tool 11 is again lowered (arrow E), as also shown in Fig. 11D. During this lowering movement of the bonding tool, a first wave crest M is partially formed in the material wire 4a.

Then, the bonding tool 11 is again pressed against the pipe body 3 with a force F while the bonding tool is supersonically vibrated in the directions of the arrows e and f, as shown in Fig. 11E. As a result, the material wire 4a is bonded to the pipe body at a second portion 26 which is spaced from the first wire portion 25 by an amount corresponding to the advancing pitch K of the pipe body. The first wave crest M of the wire is thus completed.

To form a second wave crest M, the supersonic vibration of the bonding tool 11 is interrupted, and the tool is raised (Fig. 11F) and then lowered (Fig. 11G) with the pipe body 3 advanced by another pitch K in the interim.

The finned heat transfer pipe according to the present invention can be manufactured by repeating the above process steps with respect to each wire fin 4. Obviously, the bonding portions 25, 26, and etc. provide the wave furrows 6 alternate with the wave crests 5 (or M).

When bonding a plurality of wire fins 4, the pipe body 3 need only be turned about its longitudinal axis every time the bonding operation is completed for each wire fin. At this time, the cutouts 27 of the lower jig 24 serve to accommodate those wire fins that have been bonded to the pipe body 3 prior to the one instantly undergoing the bonding operation.

According to the method shown in Figs. 11A through 11G, the bonding tool 11 is supersonically vibrated in the directions of arrows e and f, i.e., axially of the pipe body 3. This manner of vibration is preferred because the vibratory energy can be effectively transmitted to the material wire 4a "even if the pipe body is round in cross section.

The preliminary surface polishing of the pipe body 3, though not essential for the method of the present invention, is advantageous in reliably and firmly bonding the wire fins 4 to the pipe body.

Fig. 12 shows a modified heat transfer pipe which is included in the scope of the present invention. The modified heat transfer pipe comprises a pipe body 3 as well as a combination of a waved wire fin 4 and independent upright fins 28. The upright fins may be formed by first forming a continuous waved wire fin extending substantially over the entire length of the pipe body (by performing the successive steps shown in Figs. 11A through 11G), thereafter cutting the wire fin near selected bonding positions thereof, and finally erecting the cut wire portions.

The finned heat transfer pipe 2 according to the present invention has the following advantages.

(1) Each wire fin 4 is continuous, so that handling thereof for bonding to the pipe body 3 is much easier than handling a great number of separate needles. Thus, the heat transfer pipe of the present invention can be manufactured efficiently with high productivity.

(2) Substantially the entire length of the continuous waved wire fin 4 is used for heat transmission. Therefore, the actual heat transmission area per unit area of the heat transfer pipe can be made larger than that of the prior art needle fin heat transfer pipe wherein the intervals between the individual needle fins are not used for heat transmission. Thus, the heat transfer pipe of the present invention is preferred in the capability of realizing weight and size reduction to the maximum extent. In fact, the heat transfer pipe of the present invention can be rendered lighter by about 30% or more than a needle fin heat transfer pipe having the same heat transmitting capacity.

(3) The continuous waved wire fin 4 can be regarded as a single fin which is equivalent in heat transmitting capacity to a great number of needle fins. Nevertheless, the wire fin (single fin) is bonded or attached to the pipe body 3 at a plurality of positions to provide a stronger fixation than individually bonding the separate needles. Further, even if one bonding portion of the wire fin is unexpectedly detached from the pipe body, the wire fin as a whole does not come off from the pipe body. Thus, the waved wire fin is preferable in its bonding reliability, hence suitable for incorporation into a heat exchanger of an air liquefaction cycle rocket engine which requires complete preclusion of impurity entry.

On the other hand, the method of making a finned heat transfer pipe according to the present invention has the following advantages.

(1) The application of supersonic vibration enables continual bonding of the wire fin 4 with high efficiency and reliability. Particularly, the time required for completing each bonding operation is very short, so that adverse thermal influences on the pipe body 3 (e.g. thermal deformation) can be minimized. Thus, the use of a thin-walled pipe body is acceptable, consequently permitting maximum weight reduction of the heat exchanger as a whole. Further, the bonding strength obtainable by the application of supersonic vibration is very high, thereby assuring an excellent quality of the product. Moreover, the supersonic bonding enables the use of different metal materials for the wire and the pipe body. For example, an aluminum wire may be supersonically bonded to a steel pipe body, thereby realizing weight reduction.

(2) The use of the wire 4a provides easy handling, and continuous and rapid supply, thereby enhancing the productivity. Further, the use of the material wire minimizes material waste.

(3) The pitch and height (namely shape) of the waved wire fin 4 can be varied in any desired way simply by adjusting the vertical stroke of the bonding tool 11 and the advancing pitch K of the pipe body 3. Thus, it is possible to adjust the heat transmitting efficiency of the heat transfer pipe depending on the requirements of the particular application.

The present invention being thus described, it is obvious that the same may be varied in many ways. For instance, instead of intermittently advancing the pipe body 3 relative to the fixed bonding tool 11 (see Fig. 8), the bonding tool may be intermittently advanced relative to the pipe body which is held fixed. Such variations are not to be regarded as a departure from the spirit and scope of the present invention, and all such modifications as would be obvious to those skilled in the art are intended to be included within the scope of the following claims.

## Claims

1. A heat transfer pipe comprising a metallic pipe body (3), and fin means (4) attached to said pipe body; characterized in that said fin means comprises at least one metallic wire fin (4) continuously extending longitudinally of said pipe body (3), said wire fin being waved to have alternate crests (5) and furrows (6), said wire fin being attached to the outer surface of said pipe body at said furrows.

2. A heat transfer pipe as defined in claim 1, wherein said wire fin (4) is made of a metal selected from aluminum and copper.

3. A heat transfer pipe as defined in claim 1 or 2, wherein said pipe body (3) is made of a metal selected from a group consisting of stainless steel, nickel, nickel alloy, titanium, titanium alloy, niobium, niobium alloy and copper.

4. A heat transfer pipe as defined in any one of claims 1 to 3, wherein there are provided a plurality of wire fins (4) extending longitudinally of said pipe body (3) and spaced angularly from each other, each of said wire fins being waved to have alternate crests (5) and furrows (6), said each wire being attached to the outer surface of said pipe body at said furrows.

5. A heat transfer pipe as defined in any one of claims 1 to 4, wherein said wire fin (4) has a diameter of 25-500 $\mu$m.

6. A heat transfer pipe as defined in any one of claims 1 to 5, wherein said pipe body (3) is circular in cross section.

7. A heat transfer pipe as defined in any one of claims 1 to 5, wherein said pipe body (3) is polygonal in cross section.

8. A heat transfer pipe as defined in any one of claims 1 to 5, wherein said pipe body (3) is ellipsoidal in cross section.

9. A heat transfer pipe as defined in claim 6, wherein said pipe body (3) is 2-10mm in outer diameter.

10. A method of making a heat transfer pipe which comprises a metallic pipe body (3); and at least one metallic wire fin (4) continuously extending longitudinally of said pipe body, said wire fin being waved to have alternate crests (5) and furrows (6), said wire fin being attached to the outer surface of said pipe body at said furrows; said method being characterized by repeating the steps of:

causing a vibratory bonding tool (11) to press a portion (25) of a metallic wire (4a) against the outer surface of said pipe body (3) at a longitudinal position thereof while said bonding tool is supersonically vibrated, so that said portion of said wire is attached to said pipe body;

separating said bonding tool from said pipe body transversely thereof while said wire is paid out; and

causing said bonding tool to press another portion (26) of said wire against the outer surface of said pipe body at another longitudinal position thereof while said tool is supersonically vibrated, so that said another portion of said wire is attached to said pipe body with a wire part between the two adjacent attaching portions being bent to form a crest (6).

11. A method as defined in claim 10, wherein said outer surface of said pipe body (3) is preliminarily polished by one of electrolytic polishing and mechanical polishing.

12. A method as defined in claim 10 or 11, wherein said bonding tool (11) presses said wire (4a) against said outer surface of said pipe body (3) with a force of 30-1,200g.

13. A method as defined in any one of claims 10 to 12, wherein said bonding tool (11) supersonically presses said wire (4a) against said outer surface of said pipe body (3) for a period of 0.25-2 seconds each time.

14. A method as defined in any one of claims 10 to 13, wherein said bonding tool (11) and said pipe body (3) are intermittently moved relative to each other longitudinally of said pipe body, so that said wire (4a) is attached to said pipe body at a predetermined pitch (K).

15. A method as defined in claim 14, wherein said pipe body (3) is intermittently moved relative to said bonding tool (11) which is held fixed longitudinally of said pipe body.

16. A method as defined in any one of claims 10 to 15, wherein said pipe body (3) is made of a metal selected from a group consisting of stainless steel, nickel, nickel alloy, titanium, titanium alloy, niobium, niobium alloy and copper.

# Fig. 1

# Fig. 2

# Fig. 3

# Fig. 4

# Fig. 5

# Fig. 6

# Fig. 7A

# Fig. 7B

## Fig. 8

## Fig. 9

## Fig. 10

11

Fig. 11A

Fig. 11B

Fig. 11C

Fig. 11D

Fig. 11E

Fig. 11F

Fig. 11G

Fig. 13
Prior Art

Fig. 12

**European Patent Office**

**EUROPEAN SEARCH REPORT**

Application Number

**EP 90 12 0573**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-3 397 440 (DALIN)<br>* Column 3, lines 47-57; column 4, lines 15-44; figures 3-5 *<br>– – – | 1-4,6 | F 28<br>D 15/02<br>F 28 F 1/12<br>B 23 K 20/10 |
| X | FR-A-1 161 254 (HUET)<br>* Page 1, right-hand column, line 41 - page 2, left-hand column, line 12; figures 2-4 *<br>– – – | 1,4 | |
| A | WELDING INTERNATIONAL, vol. 3, no. 10, 1989, pages 853-860, Abington, Cambridge, GB; M. KODAMA: "Ultrasonic welding of non-ferrous metals"<br>* Page 857, "Ultrasonic wire banding"; figures 10,11 *<br>– – – | 1,5,10 | |
| A | PATENT ABSTRACTS OF JAPAN, vol. 12, no. 169 (M-699)[3016], 20th May 1988;<br>& JP-A-62 284 194 (TOSHIBA CORP.) 10-12-1987<br>– – – | 1 | |
| A | US-A-3 856 079 (GEPPELT)<br>* Column 1, line 38 - column 2, line 20; figures 1-5 *<br>– – – | 1 | |
| A | DE-A-3 212 372 (ALCAN OHLER GmbH)<br>* Page 9, line 11 - page 10, line 5; figure 2 *<br>– – – – – | 5 | |

| | | | TECHNICAL FIELDS SEARCHED (Int. Cl.5) |
|---|---|---|---|
| | | | F 28 D<br>F 28<br>F<br>B 23 K |

The present search report has been drawn up for all claims

| Place of search | Date of completion of search | Examiner |
|---|---|---|
| The Hague | 15 February 91 | BELTZUNG F.C. |